# EUROPÄISCHE PATENTSCHRIFT

(11) **EP 3 309 815 B1**
(45) Veröffentlichungstag und Bekanntmachung des Hinweises auf die Patenterteilung: **20.03.2019**
(21) Anmeldenummer: 16193511.9
(22) Anmeldetag: 12.10.2016
(51) Int. Cl.: H01J 37/32, H05H 1/46

(54) **PLASMABEHANDLUNGSVORRICHTUNG MIT ZWEI, MITEINANDER GEKOPPELTEN MIKROWELLENPLASMAQUELLEN SOWIE VERFAHREN ZUM BETREIBEN EINER SOLCHEN PLASMABEHANDLUNGSVORRICHTUNG**
PLASMA TREATMENT DEVICE WITH TWO MICROWAVE PLASMA SOURCES COUPLED TOGETHER AND METHOD FOR OPERATING SUCH A PLASMA TREATMENT DEVICE
DISPOSITIF DE TRAITEMENT AU PLASMA COMPRENANT DEUX SOURCES DE PLASMA EXCITÉES PAR MICRO-ONDES COUPLÉES ENSEMBLE ET PROCÉDÉ DE FONCTIONNEMENT D'UN TEL DISPOSITIF DE TRAITEMENT AU PLASMA

(43) Veröffentlichungstag der Anmeldung: 18.04.2018
(73) Patentinhaber: Meyer Burger (Germany) AG, 09337 Hohenstein-Ernstthal (DE)
(72) Erfinder: Mai, Joachim, 04603 Nobitz (DE)
(74) Vertreter: Kailuweit & Uhlemann Patentanwälte Partnerschaft mbB

(56) Entgegenhaltungen:
- WO-A1-01/39560
- WO-A1-2012/154666
- DE-A1- 10 341 239
- JP-A- H03 191 068
- US-A1- 2015 091 442

## Beschreibung

Die Erfindung betrifft eine Plasmabehandlungsvorrichtung, die zwei miteinander gekoppelte Mikrowellenplasmaquellen enthält, sowie ein Verfahren zum Betreiben einer solchen Plasmabehandlungsvorrichtung. Insbesondere ist die Plasmabehandlungsvorrichtung eine Durchlaufanlage, durch die ein zu behandelndes Substrat mittels einer Transportvorrichtung während der Plasmabehandlung hindurchgeführt wird.

Plasmabehandlungsvorrichtungen werden zur Bearbeitung von Substratoberflächen, insbesondere zur Abscheidung oder Entfernung von Schichten auf bzw. von der Substratoberfläche sowie zur Modifizierung der Eigenschaften der Substratoberfläche eingesetzt. Dabei werden die für die Bearbeitung notwendigen Teilchen (Moleküle, Atome oder elektrisch geladene Teilchen) mit Hilfe eines Plasmas angeregt oder erzeugt. Für großflächige Substrate kommen oft Durchlaufanlagen oder Inline-Anlagen zu Anwendung, in denen gegebenenfalls auch mehrere Plasmaquellen in Transportrichtung der Substrate hintereinander angeordnet sein können.

Für die Erzeugung und Aufrechterhaltung des Plasmas gibt es verschiedene Möglichkeiten des Einbringens der dafür notwendigen Energie in ein Gas oder Gasgemisch. Eine Möglichkeit ist die Anregung mittels Mikrowellen (Frequenz im Bereich von 900 MHz bis 10 GHz), womit hohe Plasmadichten im erzeugten Plasma und damit hohe Abscheideraten bzw. hohe, auf einer chemischen Reaktion basierende Ätzraten erreicht werden können. Beispielhaft sind Mikrowellenplasmaquellen in der DE 198 12 558 A1 und der DE 103 41 239 A1 beschrieben. Die mit solchen Mikrowellen angeregten Plasmen bilden bei der Wechselwirkung mit Wänden oder Substratoberflächen Plasmarandschichten mit niedrigen Randschichtpotentialen aus. Dadurch weisen die auf der Substratoberfläche auftreffenden Ladungsträger (Ionen und Elektronen) nur eine geringe Energie auf, meist kleiner als 10 eV. Zur besseren Steuerung der Bearbeitung, bspw. zur Steuerung von Schichteigenschaften wie Dichte, Festigkeit oder Stress einer abgeschiedenen Schicht, sind jedoch vor Allem für die lonenströme zur Substratoberfläche höhere und/oder steuerbare Energien wünschenswert.

Dafür kann dem Mikrowellenplasma ein elektrisches Feld überlagert werden, dessen eine Elektrode durch das zu bearbeitende Substrat bzw. einen Substratträger, auf dem das Substrat während der Bearbeitung gelagert ist, realisiert wird. Dazu wird das Substrat oder der Substratträger mit einem definierten Bezugspotential beaufschlagt, das eine Beschleunigung der auf der Substratoberfläche auftreffenden, elektrische geladenen Teilchen, insbesondere von Ionen, aus dem Plasma hin zur Substratoberfläche im elektrischen Feld bewirkt. In stationären Anlagen kann der Substratträger meist direkt kontaktiert werden. Für Durchlaufanlagen ist eine kapazitive Kopplung des Substratträgers mit einem definierten Potential, bspw. Masse, bekannt, z.B. aus der DE 10 2012 103 425 A1.

Diese rein kapazitive Kopplung des Substratträgers an ein definiertes Potential und damit die Erzeugung eines definierten elektrischen Feldes ist jedoch instabil und nur unzureichend zu steuern. Darüber hinaus kann es zur Ausbildung von parasitären Plasmen kommen, die unerwünscht sind.

WO 2012/154666 A1 offenbart eine Plasmabehandlungvorrichtumg mit einer Behandlungskammer und mindestens einem Paar von Mikrowellenplasmaquellen bestehend aus einer ersten Mikrowellenplasmaquelle und einer zweiten Mikrowellenplasmaquelle.

Es ist daher Aufgabe der vorliegenden Anmeldung, eine Plasmabehandlungsvorrichtung bereitzustellen, die eine andere Möglichkeit der Überlagerung eines elektrischen Feldes mit einem Mikrowellenplasma bietet und die Nachteile des Standes der Technik überwindet. Darüber hinaus ist es Aufgabe der vorliegenden Anmeldung, ein Verfahren zum Betreiben einer solchen Plasmabehandlungsvorrichtung bereitzustellen.

Diese Aufgabe wird gelöst durch die Plasmabehandlungsvorrichtung gemäß Anspruch 1 und das Verfahren gemäß Anspruch 14.

Vorteilhafte Weiterbildungen und Ausführungsformen finden sich in den rückbezogenen Ansprüchen.

Die erfindungsgemäße Plasmabehandlungsvorrichtung enthält eine Behandlungskammer, mindestens ein Paar von Mikrowellenplasmaquellen und mindestens eine Spannungsquelle. Die Behandlungskammer ist eine Kammer, in der die für die Plasmabehandlung eines oder mehrerer Substrate notwendigen Umgebungsbedingen, z.B. Druck oder Temperatur, eingestellt werden können. In der Behandlungskammer sind während des Betriebes der Plasmabehandlungsvorrichtung die zu behandelnden Substrate angeordnet, wobei diese während der Plasmabehandlung stationär innerhalb der Behandlungskammer angeordnet sein oder durch die Behandlungskammer hindurchtransportiert werden können.

Innerhalb der Behandlungskammer ist mindestens ein Paar von Mikrowellenplasmaquellen angeordnet. Jedes Paar von Mikrowellenplasmaquellen besteht aus einer ersten Mikrowellenplasmaquelle und einer zweiten Mikrowellenplasmaquelle. Die erste und die zweite Mikrowellenplasmaquelle weisen jeweils eine Plasmaquellenwandung und innerhalb dieser eine Mikrowelleneinkoppelvorrichtung und eine Plasmaelektrode auf. Die Plasmaquellenwandung bildet eine gasdichte Begrenzung der Mikrowellenplasmaquelle in einem ersten Bereich und weist in einem zweiten Bereich eine Plasmaaustrittsöffnung auf, durch die Teilchen während des Betriebes der Plasmabehandlungsvorrichtung aus dem Plasma in Richtung auf die zu bearbeitende Oberfläche des einen oder der mehreren Substrate austreten. Der zweite Bereich ist vorzugsweise der zu bearbeitenden Oberfläche des einen oder der mehreren Substrate zugewandt. Die erste und die zweite Mikrowellenplasmaquelle sind dabei auf derselben Seite eines oder mehrerer zu bearbeitenden Substrate und benachbart zueinander angeordnet "Auf derselben Seite eines Substrates" bedeutet, dass die Mikrowellenplasmaquellen dieselbe Oberfläche eines Substrates bearbeiten und nicht einander gegenüberliegende Oberflächen eines Substrates. "Benachbart zueinander" bedeutet, dass keine andere Plasmaquelle zwischen der ersten und der zweiten Mikrowellenplasmaquelle angeordnet ist. Der Abstand zwischen der ersten und der zweiten Mikrowellenplasmaquelle, bezogen auf die einander zugewandten Seiten der Plasmaquellenwandung ist dabei so ausgeführt, dass die technologischen Erfordernisse zur Substratbearbeitung erreicht werden. Solche Erfordernisse sind beispielsweise die Gleichmäßigkeit und Intensität der Plasmabearbeitung. Gleichzeitig ist der Abstand jedoch so bemessen, dass eine Plasmazündung im Zwischenbereich zwischen den einander zugewandten Seiten der Plasmaquellenwandungen der beiden Mikrowellenplasmaquellen vermieden oder das Risiko dafür zumindest verringert wird. Dabei sind für die Vermeidung einer solchen Plasmazündung der minimale Abstand und der maximale Abstand der beiden einander zugewandten Seiten der Plasmaquellenwandungen sowie der Verlauf des Abstandes entlang einer Richtung senkrecht zu der zu bearbeitenden Substratoberfläche von Bedeutung. Darüber hinaus ist eine Plasmazündung auch vom Druck in den Mikrowellenplasmaquellen und der Behandlungskammer sowie von der zwischen den Plasmaelektroden der Mikrowellenplasmaquellen anliegenden Spannung abhängig. Der Abstand zwischen der ersten und der zweiten Mikrowellenplasmaquelle bzw. zwischen den einander zugewandten Seiten der Plasmaquellenwandungen der beiden Mikrowellenplasmaquellen wird dabei in einer Ebene, die im Wesentlichen parallel zu der zu bearbeitenden Substratoberfläche verläuft gemessen. Die erste und die zweite Mikrowellenplasmaquelle grenzen vorzugsweise direkt aneinander. Jedoch sind in jedem Fall die Plasmaelektroden der ersten Mikrowellenplasmaquelle und der zweiten Mikrowellenplasmaquelle elektrisch isoliert voneinander. Die Gestaltung der Mikrowelleneinkoppelvorrichtungen und auch der Plasmaquellenwandungen können dabei relativ frei ausgeführt werden. So kommen als Mikrowellenplasmaquelle auch solche in Frage, die eine kreissymmetrische oder linear skalierbare Plasmaerzeugung ermöglichen.

Die mindestens eine Spannungsquelle ist mit den Plasmaelektroden der ersten und der zweiten Mikrowellenplasmaquelle elektrisch leitend verbunden und geeignet, diese mit unterschiedlichen Potentialen zu beaufschlagen. Damit dient bei angelegten Potentialen und gezündeten Plasmen das Potential der Plasmaelektrode der ersten Mikrowellenplasmaquelle, als Bezugspunkt für das Potential der Plasmaelektrode der zweiten Mikrowellenplasmaquelle. Mit anderen Worten: Zwischen den beiden Plasmaelektroden bildet sich ein elektrisches Feld aus, das zur Beschleunigung von elektrisch geladenen Teilchen, bspw. Ionen, aus zumindest einem Plasma heraus führt. Somit wird die Energie der auf der Oberfläche der zu behandelnden Substrate auftreffenden elektrisch geladenen Teilchen erhöht, ohne das Substrat mit einem definierten Bezugspotential für das Plasma jeder Mikrowellenplasmaquelle beaufschlagen oder kapazitiv mit einem solchen koppeln zu müssen. Insbesondere ist mit dieser Anordnung auch die Energie der auf der Oberfläche der zu behandelnden Substrate auftreffenden elektrisch geladenen Teilchen gut und einfach durch die Steuerung der an den Plasmaelektroden angelegten Potentiale steuerbar.

Vorzugsweise weist die Plasmabehandlungsvorrichtung eine Spannungsquelle auf, die einen ersten Ausgang und einen zweiten Ausgang aufweist und geeignet ist, zwischen dem ersten Ausgang und dem zweiten Ausgang eine Potenzialdifferenz zu erzeugen. Dabei sind das am ersten Ausgang erzeugte Potential und das am zweiten Ausgang erzeugte Potential voneinander abhängig und miteinander verknüpft. Der erste Ausgang der Spannungsquelle ist mit der Plasmaelektrode der ersten Mikrowellenplasmaquelle verbunden, während der zweite Ausgang der Spannungsquelle mit der Plasmaelektrode der zweiten Mikrowellenplasmaquelle verbunden ist.

Besonders bevorzugt ist diese Spannungsquelle eine symmetrische Spannungsquelle.

Jedoch kann die Plasmabehandlungsvorrichtung auch zwei Spannungsquellen aufweisen, wobei eine erste mit der Plasmaelektrode der ersten Mikrowellenplasmaquelle und eine zweite mit der Plasmaelektrode der zweiten Mikrowellenplasmaquelle verbunden ist, so dass die Plasmaelektroden jeweils mit voneinander vollkommen unabhängig steuerbaren Potentialen beaufschlagt werden können. Die zwei Spannungsquellen können jedoch in einem Bauteil, d.h. in einem Generator, realisiert sein.

Die mindestens eine Spannungsquelle ist eine Gleichspannungsquelle, eine gepulste Gleichspannungsquelle oder eine Wechselspannungsquelle, wobei eine Gleichspannungsquelle oder eine gepulste Gleichspannungsquelle jedoch hauptsächlich bei zwei getrennten Spannungsquellen für die Plasmaelektroden der beiden Mikrowellenplasmaquellen zum Einsatz kommen. Die Frequenzen der bereitgestellten gepulsten Gleichspannungen bzw. der Wechselspannungen liegen im Bereich von wenigen Hz bis einige Hundert MHz.

Die erfindungsgemäße Plasmabehandlungsvorrichtung kann auch mehr als ein Paar von Mikrowellenplasmaquellen enthalten. Das heißt, es können zwei, drei oder mehr Paare von Mikrowellenplasmaquellen in der Behandlungskammer angeordnet sein, wobei die Plasmaelektroden aller jeweils ersten Mikrowellenplasmaquellen mit demselben Potential und die Plasmaelektroden aller jeweils zweiten Mikrowellenplasmaquellen mit einem anderen gemeinsamen Potential beaufschlagt werden können. Dazu kann eine gemeinsame Spannungsquelle für alle Plasmaelektroden oder eine gemeinsame Spannungsquelle für die Plasmaelektroden aller jeweils ersten Mikrowellenplasmaquellen und eine andere gemeinsame Spannungsquelle für die Plasmaelektroden aller jeweils zweiten Mikrowellenplasmaquellen eingesetzt werden. Dabei ist es möglich, erste und zweite Mikrowellenplasmaquellen alternierend anzuordnen oder eine erste Mikrowellenplasmaquelle eines ersten Paares von Mikrowellenplasmaquellen neben einer ersten Mikrowellenplasmaquelle eines anderen Paares von Mikrowellenplasmaquellen zu positionieren. Des Weiteren können auch verschiedene Spannungsquellen genutzt und/oder verschiedene Potentiale an die Plasmaelektroden der ersten bzw. zweiten Mikrowellenplasmaquellen zugeführt werden. Es sind Kombinationen verschiedener beschriebener Varianten möglich.

In einer bevorzugten Ausführungsform weist mindestens eine der ersten oder der zweiten Mikrowellenplasmaquelle innerhalb der Plasmaquellenwandung einen gegenüber Masse isolierten Plasmaschirm auf, der einen Plasmaraum der Mikrowellenplasmaquelle zumindest teilweise umgibt und als Plasmaelektrode dient. Der Plasmaraum ist der Bereich der Mikrowellenplasmaquelle, in dem das Plasma ausgebildet ist. Der Plasmaschirm ist elektrisch von der Plasmaquellenwandung, die bspw. geerdet sein kann, isoliert und weist mindestens einen Gasdurchlass auf, durch den Gas in den Plasmaraum einströmen kann. Bevorzugt ist dieser Plasmaschirm als ein gasdurchlässiges, elektrisch leitfähiges Lochblech oder Netz ausgebildet. Darüber hinaus weist der Plasmaschirm mindestens eine Öffnung in einem, dem zu bearbeitenden Substrat zugewandten Bereich auf, durch den Teilchen aus dem Plasma zur Oberfläche des zu bearbeitenden Substrats austreten können.

In einer anderen bevorzugten Ausführungsform ist die Plasmaquellenwandung mindestens einer der ersten oder der zweiten Mikrowellenplasmaquelle gegen Masse isoliert und dient als Plasmaelektrode. Dabei kann die Mikrowellenplasmaquelle einen Plasmaschirm aufweisen, der elektrisch mit der Plasmaquellenwandung leitend verbunden ist, oder ohne einen solchen Plasmaschirm ausgebildet sein.

In beiden Ausführungsformen sind alle Versorgungsleitungen und mechanischen Halterungen, die im Plasmaraum angeordnet sind oder zu diesem hinführen, elektrisch gegen Masse isoliert, um die Ausbildung einer definierten Spannung über das Plasma mittels des an der Plasmaelektrode beaufschlagten Potentials zu gewährleisten.

In einer weiteren bevorzugten Ausführungsform weisen die einander zugewandten Seiten der Plasmaquellenwandung der ersten und der zweiten Mikrowellenplasmaquellen einen größeren Abstand zur Oberfläche des einen oder der mehreren zu bearbeitenden Substrate auf als die übrigen Seiten der Plasmaquellenwandungen.

In einer bevorzugten Anordnung ist mindestens eine der beiden Mikrowellenplasmaquellen gegenüber der anderen Mikrowellenplasmaquelle bzw. gegenüber der Oberfläche der zu bearbeitenden Substrate geneigt angeordnet. Besonders bevorzugt sind beide Mikrowellenplasmaquellen in gleicher Weise zueinander geneigt. Unter einer geneigten Anordnung der Mikrowellenplasmaquellen wird eine Anordnung verstanden, bei der der Winkel zwischen der Ebene der Plasmaaustrittsöffnung der Mikrowellenplasmaquelle und der zu bearbeitenden Substratoberfläche größer 0 (Null) und kleiner oder gleich 90° ist wobei die Plasmaaustrittsöffnung der geneigten Mikrowellenplasmaquelle in die Richtung der anderen Mikrowellenplasmaquelle des Paares von Mikrowellenplasmaquellen zeigt Hierbei ergibt sich für die einander zugewandten Plasmaquellenwandungen ein vergrößerter Abstand zur Substratebene als in den nach außen gerichteten Bereichen. Je nach Neigung und Abstand der Mikrowellenplasmaquellen ergeben sich dadurch mehr oder weniger große Überlappungsbereiche der einzelnen mit den Mikrowellenplasmaquellen erzeugten Mikrowellenplasmen. Ist eine Mikrowellenplasmaquelle nicht geneigt, so ist die Ebene der Plasmaaustrittsöffnung der Mikrowellenplasmaquelle parallel zu der zu bearbeitenden Substratoberfläche.

Vorteilhafterweise weisen die Mikrowellenplasmaquellen Magnete bzw. Magnetanordnungen auf, die die Extraktion der Ladungsträger aus den Mikrowellenplasmen beeinflussen. Dabei sind die sich gegenüberliegenden Magnete der ersten und der zweiten Mikrowellenplasmaquellen zueinander entweder gleichpolig oder gegenpolig angeordnet, um eine gewünschte Extraktion der Ladungsträger zu erhalten. "Sich gegenüberliegende Magnete" sind dabei diejenigen Magnete, die an den einander zugewandten Seiten der Plasmaquellenwandungen der beiden Mikrowellenplasmaquellen angeordnet sind.

Darüber hinaus ist in einer besonders bevorzugten Ausführungsform zwischen den einander zugewandten Seiten der Plasmaquellenwandung der ersten und der zweiten Mikrowellenplasmaquellen ein Gaseinlass angeordnet. Dieser ist geeignet, ein Gas in einen Verbindungsbereich zwischen der ersten und der zweiten Mikrowellenplasmaquelle, der an die Oberfläche des einen oder der mehreren zu bearbeitenden Substrate angrenzt, einzulassen. Damit kann während des Betriebs der Mikrowellenplasmaquellen ein Verbindungsbereich zwischen den Plasmaräumen der beiden Mikrowellenplasmaquellen geschaffen werden, dereine erhöhte elektrische Leitfähigkeit gegenüber den übrigen Bereichen der Behandlungskammer aufweist und eine elektrische leitende Verbindung zwischen den beiden Plasmaräumen ermöglicht oder verbessert.

In einer anderen bevorzugten Ausführungsform weist die Plasmabehandlungsvorrichtung einen gemeinsamen Mikrowellenleistungsteiler für die erste und die zweite Mikrowellenplasmaquelle auf. Somit können neue, kompakte Plasmabehandlungsvorrichtungen aufgebaut und die beiden erzeugten Mikrowellenplasmen besser aufeinander abgestimmt und Bauteile und damit Kosten eingespart werden.

Die erfindungsgemäße Plasmabehandlungsvorrichtung ist besonders für die Behandlung von Substraten, die während der Bearbeitung durch die Behandlungskammer hindurchbewegt werden, und damit als Durchlauf-Anlage geeignet. Dafür enthält die Plasmabehandlungsvorrichtung vorzugsweise weiterhin eine Transportvorrichtung, die geeignet ist, mindestens einen Substratträger, auf dem das eine oder die mehreren zu bearbeitenden Substrate angeordnet sind, während des Betriebes der ersten und der zweiten Mikrowellenplasmaquellen durch die Behandlungskammer zu transportieren.

Vorzugsweise besteht der Substratträger dabei aus einem elektrisch leitfähigen Material. Damit wird der Substratträger in den Stromkreis zwischen den beiden Plasmaelektroden eingebunden und bildet einen Spannungsteiler.

Jedoch können auch elektrisch kaum oder nicht leitende Substratträger zum Einsatz kommen. In diesem Fall sollte der Abstand zwischen den einander zugewandten Seiten der Plasmaquellenwandung der ersten und der zweiten Mikrowellenplasmaquellen möglichst klein und der Abstand der einander zugewandten Seiten der Plasmaquellenwandung der ersten und der zweiten Mikrowellenplasmaquellen zur Oberfläche der zu bearbeitenden Substrate größer als der der übrigen Seiten der Plasmaquellenwandungen sein, wie dies bereits mit Bezug auf eine bevorzugte Ausführungsform der Plasmabehandlungsvorrichtung erläutert wurde. Diese Ausführungsform der Plasmabehandlungskammer ermöglicht die Ausbildung eines Verbindungsbereiches zwischen den Plasmaräumen der beiden Mikrowellenplasmaquellen während des Betriebs der Mikrowellenplasmaquellen, der eine elektrische leitende Verbindung zwischen den beiden Plasmaräumen ermöglicht oder verbessert.

Das erfindungsgemäße Verfahren zum Betreiben der erfindungsgemäßen Plasmabehandlungsvorrichtung enthält das Zünden jeweils eines Plasmas in der ersten und der zweiten Mikrowellenplasmaquelle mit Hilfe einer Mikrowellenleistung sowie das Beaufschlagen der Plasmaelektroden der ersten Mikrowellenplasmaquelle und der zweiten Mikrowellenplasmaquelle mit unterschiedlichen Potentialen während der Aufrechterhaltung der Plasmen. Die Potentiale werden mit Hilfe der mindestens einen Spannungsquelle den Plasmaelektroden zugeführt, wobei jedes dieser Potentiale für die Plasmaelektrode der anderen Mikrowellenplasmaquelle als Bezugspotential dient.

Damit fällt zwischen den Plasmaelektroden der ersten und der zweiten Mikrowellenplasmaquelle eine Spannung ab, die durch die von der mindestens einen Spannungsquelle den Plasmaelektroden zugeführten Potentiale bestimmt wird. Diese Spannung ist entsprechend der Ausgestaltung der mindestens einen Spannungsquelle eine Gleichspannung, eine gepulste Gleichspannung oder eine Wechselspannung.

Vorzugsweise werden das eine oder die mehreren zu bearbeitenden Substrate während des Betriebes der ersten und der zweiten Mikrowellenplasmaquellen durch die Plasmabehandlungsvorrichtung transportiert. Dabei sind das oder die Substrate auf mindestens einem Substratträger angeordnet, die bereits in Bezug auf die Plasmabehandlungsvorrichtung beschrieben wurden.

In einer weiteren bevorzugten Ausführungsform werden die Mikrowelleneinkoppelvorrichtungen der ersten und der zweiten Mikrowellenplasmaquelle mit einer phasengleich gepulsten oder einer zueinander phasenversetzt gepulsten Mikrowellenleistung betrieben. Außerdem erfolgt die Pulsung der Mikrowellenleistung einer jeden Mikrowellenplasmaquelle bevorzugt auch synchronisiert zu der von der mindestens einen Spannungsquelle bereitgestellten Spannung zwischen den Plasmaelektroden.

Im Nachfolgenden soll die Erfindung anhand von Ausführungsbeispielen und Figuren verdeutlicht werden.

Es zeigen:
- Fig. 1: eine erste Ausführungsform (1a) der erfindungsgemäßen Plasmabehandlungsvorrichtung, in der ein Plasmaschirm (22) jeder der Mikrowellenplasmaquellen (20a, 20b) als jeweilige Plasmaelektrode (28) dient,
- Fig. 2: eine zweite Ausführungsform (1b) der erfindungsgemäßen Plasmabehandlungsvorrichtung, in der eine Plasmaquellenwandung (21) jeder der Mikrowellenplasmaquellen (20a, 20b) als jeweilige Plasmaelektrode (28) dient,
- Fig. 3: eine dritte Ausführungsform (1c) der erfindungsgemäßen Plasmabehandlungsvorrichtung, in der die einander zugewandten Seiten der Plasmaquellenwandungen (21) der Mikrowellenplasmaquellen (20a, 20b) gegenüber der Oberfläche der zu bearbeitenden Substrate (13) zurückgesetzt ist,
- Fig. 4: eine vierte Ausführungsform (1d) der erfindungsgemäßen Plasmabehandlungsvorrichtung, in der die Mikrowellenplasmaquellen (20a, 20b) gegenüber der Oberfläche der zu bearbeitenden Substrate (13) geneigt sind, und
- Fig. 5: eine schematische Darstellung einer Ausführungsform einer Prozesstrommelanlage (100), die zwei erfindungsgemäße Plasmabehandlungsvorrichtungen (1e, 1f) enthält

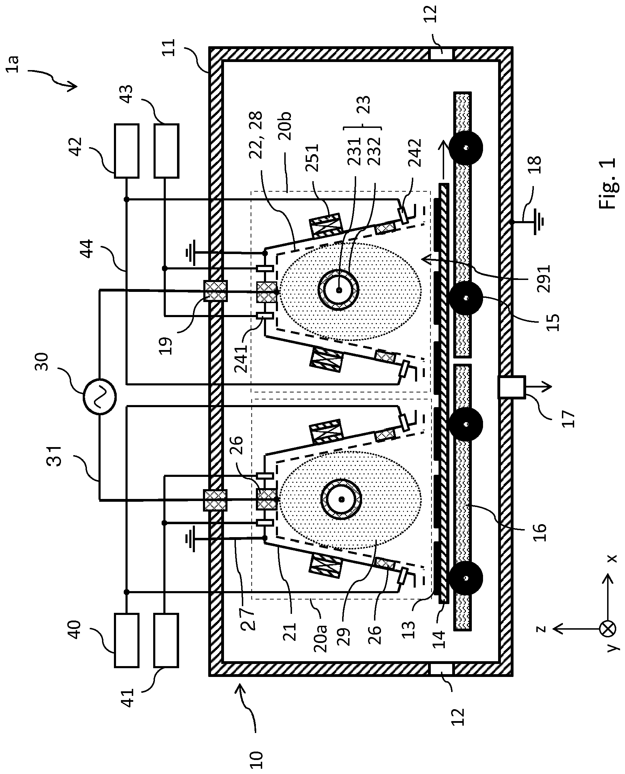

In **Figur 1** ist eine erste Ausführungsform (1a) der erfindungsgemäßen Plasmabehandlungsvorrichtung im Querschnitt durch eine Behandlungskammer (10), dargestellt, wobei Komponenten der Plasmabehandlungsvorrichtung, die außerhalb der Behandlungskammer (10) angeordnet sind, nur schematisch dargestellt sind. Dies sind insbesondere eine Spannungsquelle (30) mit den zugehörigen elektrischen Zuleitungen (31) sowie Gasversorgungen (40 bis 43) mit den zugehörigen Gaszuleitungen (44).

Die Behandlungskammer (10) weist eine Kammerwand (11) auf, in die ein oder mehrere Öffnungsspalte (12) eingebracht sind. Die Öffnungsspalte (12) dienen zum Ein- bzw. Ausfahren eines oder mehrerer, in der Behandlungskammer zu behandelnden Substrate (13) oder eines oder mehrerer Substratträger (14), auf dem bzw. denen die zu behandelnden Substrate (13) angeordnet sind. Dabei können die Substrate (13) während der Plasmabehandlung in der Behandlungskammer (10) stationär positioniert oder bewegt werden. Insbesondere kann die Plasmabehandlungsvorrichtung (1a) eine Durchlaufanlage sein, wie dies in Fig. 1 dargestellt ist, bei der die Substrate (13) während der Behandlung kontinuierlich durch die Behandlungskammer (10) mittels einer Transportvorrichtung (15) entlang einer ersten Richtung (hier die x-Richtung) von einem ersten Öffnungsspalt (12) zu einem, an der gegenüberliegenden Kammerwand (11) befindlichen zweiten Öffnungsspalt (12) bewegt werden. Dies ist durch den Pfeil mit Bezug auf den Substratträger (14) dargestellt. In der Behandlungskammer (10) können Heizer (16) oder Kühlvorrichtungen angeordnet sein, die eine definierte Temperatur der Substrate (13) während der Behandlung gewährleisten. Weiterhin weist die Behandlungskammer (10) üblicherweise einen Pumpenanschluss (17) auf, der mit einer Absaugpumpe verbunden ist und das Abpumpen von Gas aus der Behandlungskammer (10) ermöglicht. Darüber hinaus sind in der Kammerwand (11), die mit einer Erdung (18) versehen ist, isolierte elektrische Durchführungen (19) eingebracht.

In der Behandlungskammer ist mindestens ein Paar von Mikrowellenplasmaquellen (20a, 20b) angeordnet, wobei jedes Paar aus einer ersten Mikrowellenplasmaquelle (20a) und einer zweiten Mikrowellenplasmaquelle (20b) besteht. Die erste Mikrowellenplasmaquelle (20a) und die zweite Mikrowellenplasmaquelle (20b) sind in den dargestellten Figuren jeweils gleichartig ausgebildet, wobei dies nicht zwingend notwendig ist. Um die Übersichtlichkeit der Darstellung zu wahren, sind baugleiche Komponenten in beiden Mikrowellenplasmaquellen (20a, 20b) nur mit Bezug auf eine der Mikrowellenplasmaquellen (20a oder 20b) mit einem Bezugszeichen versehen. In der ersten Ausführungsform (1a) der Plasmabehandlungsvorrichtung enthält jede Mikrowellenplasmaquelle (20a, 20b) eine Plasmaquellenwandung (21), einen Plasmaschirm (22), eine Mikrowelleneinkoppelvorrichtung (23), Gaseinlässe (241, 242) sowie Magnete (251).

Die Plasmaquellenwandung (21) bildet eine geschlossene räumliche Umhüllung eines Plasmaraums (29) mit Ausnahme einer Plasmaaustrittsöffnung (291), durch die Teilchen aus dem Plasmaraum (29) zu einer zu behandelnden Oberfläche der Substrate (13) hin austreten können.

Die Gaseinlässe (241, 242) können bspw. an der Oberseite der Plasmaquellenwandung (21), welche die von den zu behandelnden Substraten (13) abgewandte Seite der Plasmaquellenwandung (21) ist, und in seitlichen Bereichen der Plasmaquellenwandung (21) nahe der Substrate (13) angeordnet sein und werden im Folgenden als obere Gaseinlässe (241) und seitliche Gaseinlässe (242) bezeichnet. Sie sind jeweils über Gaszuleitungen (44) mit Gasversorgungen (40 bis 43) verbunden. Im dargestellten Fall, sind die seitlichen Gaseinlässe (242) der ersten Mikrowellenplasmaquelle (20a) mit einer ersten Gasversorgung (40), die oberen Gaseinlässe (241) der ersten Mikrowellenplasmaquelle (20b) mit einer zweiten Gasversorgung (41), die seitlichen Gaseinlässe (242) der zweiten Mikrowellenplasmaquelle (20b) mit einer dritten Gasversorgung (42) und die oberen Gaseinlässe (241) der zweiten Mikrowellenplasmaquelle (20b) mit einer vierten Gasversorgung (43) verbunden. Vorzugsweise stellen die erste und die dritte Gasversorgung (40, 42) jeweils andere Gase zur Verfügung als die zweite und vierte Gasversorgung (41, 43). Dies ist insbesondere dann von Vorteil, wenn das über die seitlichen Gaseinlässe (242) eingespeiste Gas nicht so stark durch ein Plasma, das in der Mikrowellenplasmaquelle (20a, 20b) erzeugt wird, beeinflusst werden soll wie die über die oberen Gaseinlässe (241) eingespeisten Gase. Für eine effektive Gasausnutzung sollten Gase mit einer besonders hohen Reaktivität näher an der Substratoberfläche bereitgestellt werden als Gase mit einer niedrigen Reaktivität. Darüber hinaus können auch alle Gasversorgungen (40 bis 43) unterschiedliche Gase zur Verfügung stellen, wie dies in Fig. 1 angedeutet ist.

Der Plasmaschirm (22) ist elektrisch von der Plasmaquellenwandung (21) durch die elektrische Isolierung (26) getrennt. Damit kann die Plasmaquellenwandung (21) über eine elektrische Verbindung (27) zur Masse geerdet sein, während der Plasmaschirm (22) mit der Spannungsquelle (30) elektrisch leitend verbunden ist und als Plasmaelektrode (28) dient. Während des Betriebes der Mikrowellenplasmaquellen (20a, 20b) wird durch das Zuführen von Energie mittels Mikrowellen über die Mikrowelleneinkoppelvorrichtung (23) ein Plasma gezündet, das den Plasmaraum (29) der Mikrowellenplasmaquelle (20a, 20b) ausfüllt. Die räumliche Ausdehnung und Position des Plasmaraums (29) wird durch die Bauform der Mikrowellenplasmaquelle (20a, 20b), die eingespeiste Mikrowellenenergie sowie die Ausgestaltung und Anordnung der Magnete (251) bestimmt. Der Plasmaraum (29) kann dabei bis an die Oberfläche der Substrate (13) heranreichen, jedoch kann die untere Grenze des Plasmaraums (29) auch entlang der z-Richtung von der Oberfläche der Substrate (13) beabstandet sein. Die Mikrowelleneinkoppelvorrichtung (23) enthält einen Innenleiter (231), der mit einer Mikrowellenversorgung verbunden ist, welche in Fig. 1 nicht dargestellt ist, sowie ein Isolierrohr (232), das den Innenleiter (231) elektrisch von der Umgebung isoliert.

Die erste und die zweite Mikrowellenplasmaquellen (20a, 20b) können, wie in Fig. 1 dargestellt, in Durchlaufrichtung der Substrate (x-Richtung) nebeneinander oder auch quer zur Durchlaufrichtung der Substrate, d.h. in y-Richtung, nebeneinander angeordnet sein.

Erfindungsgemäß sind die Plasmaelektroden (28) der ersten und der zweiten Mikrowellenplasmaquellen (20a, 20b) so mit mindestens einer Spannungsquelle (30) elektrisch leitend verbunden, dass sie während des Betriebes der Mikrowellenplasmaquellen (20a, 20b) mit voneinander verschiedenen Potentialen beaufschlagt werden. Im ersten Ausführungsbeispiel weist die Plasmabehandlungsvorrichtung (1a) nur eine Spannungsquelle (30) auf, wobei die Plasmaelektrode (28) der ersten Mikrowellenplasmaquelle (20a) mit einem ersten Ausgang der Spannungsquelle (30) und die Plasmaelektrode (28) der zweiten Mikrowellenplasmaquelle (20b) mit einem zweiten Ausgang der Spannungsquelle (30) verbunden sind. Dabei können die am ersten und am zweiten Ausgang der Spannungsquelle (30) erzeugten Potentiale symmetrisch zu Masse sein, d.h. das erste Potential und das zweite Potential sind betragsmäßig gleich, haben jedoch unterschiedliche Vorzeichen. Sind die erste und die zweite Mikrowellenplasmaquelle (20a, 20b) gleichartig gebaut und werden mit den gleichen Parametern betrieben (Mikrowellenleistung, Gasfluss und Gaszusammensetzung), so fallen gleiche Spannungen über den Plasmen der beiden Mikrowellenplasmaquellen (20a, 20b) ab, die jeweils die Hälfte der von der Spannungsquelle (30) bereitgestellten Spannung ist. Selbstverständlich können die Potentiale an den beiden Ausgängen der Spannungsquelle (30) auch unsymmetrisch bezüglich Masse sein, so dass die über den Plasmen der beiden Mikrowellenplasmaquellen abfallende Spannung nur jeweils in etwa der Hälfte der von der Spannungsquelle (30) bereitgestellten Spannung entspricht Bei Vorhandensein nur einer Spannungsquelle (30) sind jedoch die Potentiale an den Plasmaelektroden (28) der ersten und der zweiten Mikrowellenplasmaquellen (20a, 20b) jeweils voneinander abhängig und miteinander verknüpft.

Der Substratträger (14) besteht vorzugsweise aus einem elektrisch gut leitfähigen Material, wie bspw. Graphit, Aluminium oder einem Verbundwerkstoff (z.B. CFC), und leitet somit den Strom zwischen dem Bereich des Substratträgers (14) unterhalb des Plasmaraums (29) der ersten Mikrowellenplasmaquelle (20a) und dem Bereich des Substratträgers (14) unterhalb des Plasmaraums (29) der zweiten Mikrowellenplasmaquelle (20b) ohne einen nennenswerten Spannungsabfall. Damit können die erste und die zweite Mikrowellenplasmaquelle (20a, 20b) unabhängig voneinander angeordnet sein, insbesondere auch mit einem großen Abstand zueinander entlang der x-Richtung. Um den Stromfluss im Durchlaufbetrieb kontinuierlich zu gewährleisten, sollten aufeinanderfolgende Substratträger (14) durch ein elektrisch leitfähiges Element miteinander verbunden sein, so dass der Abstand zwischen den aufeinanderfolgenden Substratträgern (14) überbrückt wird. Dies können bspw. von einem Ende eines Substratträgers (14) ausragende Elemente sein, die auf einem vor oder nach dem betreffenden Substratträger (14) befindlichen, anderen Substratträger (14) aufliegen und den elektrischen Kontakt herstellen.

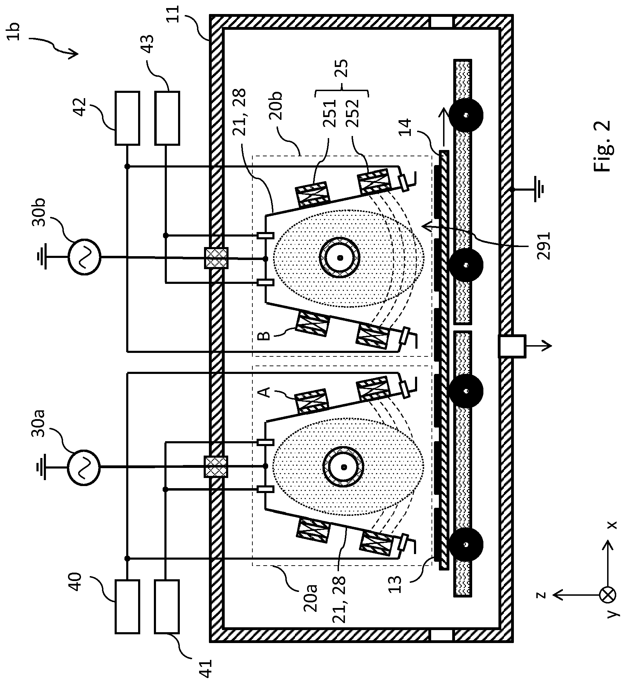

In **Figur 2** ist eine zweite Ausführungsform (1b) der erfindungsgemäßen Plasmabehandlungsvorrichtung dargestellt, die sich von der ersten Ausführungsform (1a) dadurch unterscheidet, dass die Mikrowellenplasmaquellen (20a, 20b) jeweils keinen Plasmaschirm enthalten, sondern die Plasmaquellenwandung (21) jeweils als Plasmaelektrode (28) dient. In diesem Fall ist die gesamte Mikrowellenplasmaquelle (20a, 20b) jeweils gegen Masse isoliert.

Darüber hinaus ist in Figur 2 dargestellt, dass auch zwei verschiedene, jeweils auf Masse bezogene Spannungsquellen (30a, 30b) zur Bereitstellung der Potentiale an die Plasmaelektroden (28) genutzt werden können. Dabei beaufschlagt eine erste Spannungsquelle (30a) die Plasmaelektrode (28) der ersten Mikrowellenplasmaquelle (20a) mit einem ersten Potential und die zweite Spannungsquelle (30b) die Plasmaelektrode (28) der zweiten Mikrowellenplasmaquelle (20b) mit einem zweiten Potential, welches vollkommen unabhängig vom ersten Potential eingestellt werden kann. Die erste und die zweite Spannungsquelle (30a, 30b) können dabei auch in einem Generator realisiert sein, solange die Unabhängigkeit der bereitgestellten Potentiale voneinander gewährleistet ist. Damit können bei entsprechenden, zugeführten Potentialen unterschiedliche Spannungen über den Plasmen der beiden Mikrowellenplasmaquellen (20a, 20b) abfallen. Das ist besonders dann sinnvoll, wenn die Mikrowellenplasmaquellen mit unterschiedlichen Betriebsparametern, wie Mikrowellenleistungen oder Gasflüssen oder Gasmischungen usw. betrieben werden. Der Transport von Ladungsträgern aus den jeweiligen Mikrowellenplasmen zu den Substratoberflächen unterscheidet sich dann und kann mit Hilfe der unterschiedlichen Spannungen beeinflusst oder ausgeglichen werden. Im Falle von gepulsten Mikrowellenleistungen kann die Höhe der Mikrowellenleistung als auch die Phasenlage zwischen den einzelnen Mikrowellenplasmaquellen synchronisiert und abgestimmt mit den Spannungsquellen an den jeweiligen Plasmaelektroden erfolgen.

Weiterhin weist jede Mikrowellenplasmaquelle (20a, 20b) eine Magnetanordnung (25) auf, die erste Magnete (251) und zweite Magnete (252) enthält. Die Permanentmagnete (252), die sich direkt am Bereich der Plasmaaustrittsöffnung (291) der jeweiligen Mikrowellenplasmaquelle gegenüberliegen, sind mit einer gegenpoligen Polarität versehen. Zwischen den Magnetpolen dieser Permanentmagnete (252) bilden sich geschlossene magnetische Feldlinien aus (in Fig. 2 als gestrichelte Linien dargestellt), wodurch ein magnetischer Spiegel erzeugt wird. Damit ist es z.B. möglich, die Extraktion von Elektronen gegenüber der Extraktion von Ionen aus dem Plasmaraum zu unterdrücken. Dabei können verschiedene Magnete (251, 252) einer Magnetanordnung (25) einer Mikrowellenplasmaquelle (20a oder 20b) oder beider Mikrowellenplasmaquellen (20a und 20b) die Plasmaausbildung und/oder die Ladungsträgerextraktion vorteilhaft beeinflussen. So können sich gegenüberliegende Magnete (251, 252) der beiden Mikrowellenplasmaquellen, bspw. die in Fig. 2 durch die Bezugszeichen A und B gekennzeichneten ersten Magnete (251), gleich- oder gegenpolig zueinander ausgebildet sein.

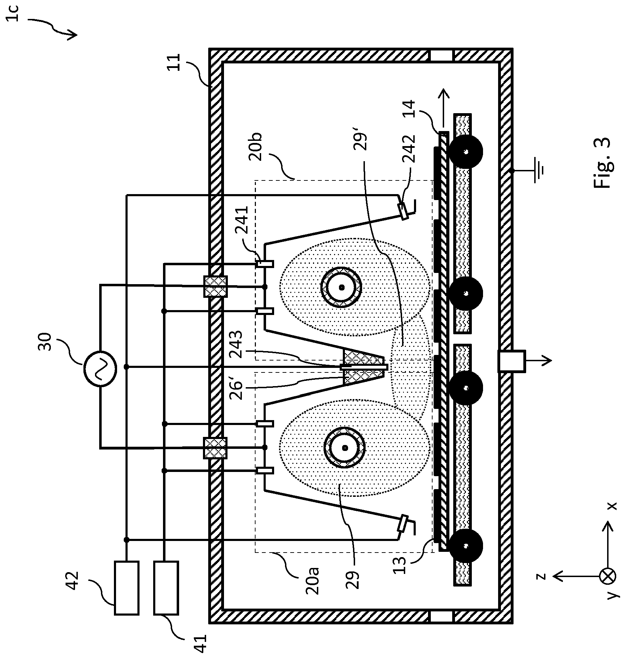

**Figur 3** zeigt eine dritte Ausführungsform (1c) der erfindungsgemäßen Plasmabehandlungsvorrichtung, wobei in beiden Mikrowellenplasmaquellen (20a, 20b) die Plasmaquellenwandung (21) als Plasmaelektrode (28) dient. In der dritten Ausführungsform (1c) sind dabei die erste und die zweite Mikrowellenplasmaquelle (20a, 20b) sehr nah nebeneinander entlang der x-Richtung positioniert. Die Dimensionierung des Abstandes richtet sich nach den physikalischen Bedingungen zur Vermeidung einer Plasmazündung zwischen den Plasmaquellenwandungen zueinander und ist von der Höhe der Spannungspotentiale, des Prozessdruckes und den eingesetzten Prozessgasen abhängig. Des Weiteren sind die einander zugewandten Seiten der Plasmaquellenwandung (21) voneinander durch eine Isolierung (26') elektrisch isoliert und gegenüber der zu behandelnden Oberfläche der Substrate (13) zurückgesetzt. D.h. die Plasmaquellenwandung (21) der ersten Mikrowellenplasmaquelle (20a) endet auf der, der zweiten Mikrowellenplasmaquelle (20b) zugewandten Seite an einer Position oberhalb der Substrate (13) mit einem größeren Abstand entlang der z-Richtung zur Oberfläche der Substrate (13) als auf der, der zweiten Mikrowellenplasmaquelle (20b) abgewandten Seite. Für die zweite Mikrowellenplasmaquelle (20b) gilt dies entsprechend. Darüber hinaus ist zwischen den beiden einander zugewandten Seiten der Plasmaquellenwandung (21) der beiden Mikrowellenplasmaquellen (20a, 20b) ein gemeinsamer mittlerer Gaseinlass (243) angeordnet, der gemeinsam mit den seitlichen Gaseinlässen (242) der ersten und der zweiten Mikrowellenplasmaquellen (20a, 20b) an eine gemeinsame Gasversorgung (41) angeschlossen ist. Auch die oberen Gaseinlässe (241) der beiden Mikrowellenplasmaquellen (20a, 20b) sind an eine gemeinsame, jedoch andere Gasversorgung (40) angeschlossen. Durch den sehr kleinen Abstand der beiden Mikrowellenplasmaquellen (20a, 20b) zueinander entlang der x-Richtung, die zurückgezogenen Plasmaquellenwandungen (21) auf der einander zugewandten Seite und dem dort positionierten Gaseinlass (243) bildet sich während des Betriebes der Mikrowellenplasmaquellen (20a, 20b) ein Plasma in einem Verbindungsbereich (29') aus, der die beiden eigentlichen Plasmaräume (29) der Mikrowellenplasmaquellen (20a, 20b) miteinander verbindet. Damit kann die elektrische Verbindung zwischen den Plasmen der beiden Mikrowellenplasmaquellen (20a, 20b) auch für elektrisch nicht- oder schlecht leitende Substratträger (14) realisiert werden. Auch für den Fall, dass aufeinanderfolgende, elektrisch gut leitende Substratträger (14) nicht elektrisch leitend miteinander verbunden sind, kann damit eine kontinuierliche Behandlung der Substrate (13) in einer Durchlaufanlage gewährleistet werden.

Weiterhin weisen die Mikrowellenplasmaquellen (20a, 20b) der dritten Ausführungsform (1c) keine Magnete auf, die auch in den übrigen Ausführungsformen jeweils nur optional sind.

Sowohl die Art der Gasversorgung, als auch die Art der Spannungsquelle und der baulichen Ausgestaltung der einzelnen Mikrowellenplasmaquellen, bspw. ob mit oder ohne Plasmaschirm oder Magnete, kann frei gewählt werden, so dass die Komponenten der in den Fig. 1 bis 3 dargestellten Ausführungsbeispiele miteinander kombinierbar sind, soweit sie sich nicht gegenseitig ausschließen. Auch weitere nicht dargestellte Magnetanordnungen zur Formung und Beeinflussung der Plasmaausbildung der einzelnen Mikrowellenplasmaquellen sind dem Fachmann bekannt und Optionen für die Ausgestaltung der Mikrowellenplasmaquellen.

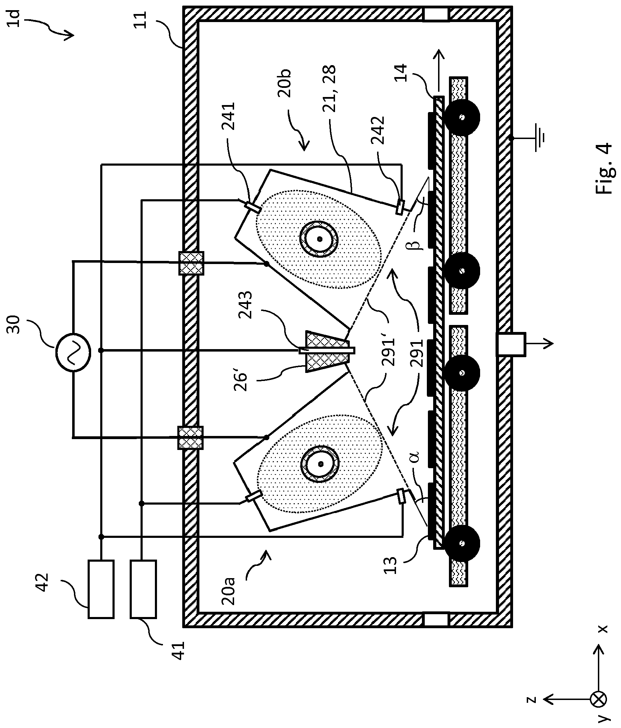

In **Figur 4** ist eine vierte Ausführungsform (1d) der erfindungsgemäßen Plasmabehandlungsvorrichtung dargestellt, bei der die Mikrowellenplasmaquellen (20a, 20b) gegenüber der Oberfläche der zu bearbeitenden Substrate (13) geneigt angeordnet sind. Dabei ist ein erster Winkel zwischen der Ebene (291') der Plasmaaustrittsöffnung (291) der ersten Mikrowellenplasmaquelle (20a) und der zu bearbeitenden Substratoberfläche mit α bezeichnet, während ein zweiter Winkel zwischen der Ebene (291') der Plasmaaustrittsöffnung (291) der zweiten Mikrowellenplasmaquelle (20b) und der zu bearbeitenden Substratoberfläche mit β bezeichnet ist. Beide Winkel α und β sind in der dargestellten beispielhaften Ausführungsform gleich groß und betragen ca. 30°. Dadurch ergibt sich für die einander zugewandten Seiten der Plasmaquellenwandungen (21) ein vergrößerter Abstand zur Substratebene, d.h. entlang der z-Richtung, als in den nach außen gerichteten Bereichen. Die einander zugewandten Seiten der Plasmaquellenwandungen (21) sind, wie bereits mit Bezug auf Fig. 3 erläutert, durch eine Isolierung (26') elektrisch voneinander isoliert. Zwischen den Plasmaaustrittsöffnungen (291) der Mikrowellenplasmaquellen (20a, 20b) und den auf dem Substratträger (14) angeordneten Substraten (13) ergibt sich ein Bereich, in dem sich die Mikrowellenplasmen der beiden Mikrowellenplasmaquellen (20a, 20b) oder zumindest die von ihnen ausgehenden Teilchenströme überlappen. Im dargestellten Fall sind beide Mikrowellenplasmaquellen (20a, 20b) in gleicher Weise gegenüber der Oberfläche der zu bearbeitenden Substrate (13) geneigt angeordnet. Jedoch können die erste und die zweite Mikrowellenplasmaquelle (20a, 20b) auch unterschiedliche Neigungswinkel aufweisen, wobei die Winkel α und β jeweils einen Wert größer 0 (Null) und kleiner oder gleich 90° annehmen. Die Mikrowellenplasmaquellen sind dabei immer einander zugeneigt angeordnet, so dass die beiden Plasmaaustrittsöffnungen (291) immer einander zumindest in kleinem Maße zugewandt sind.

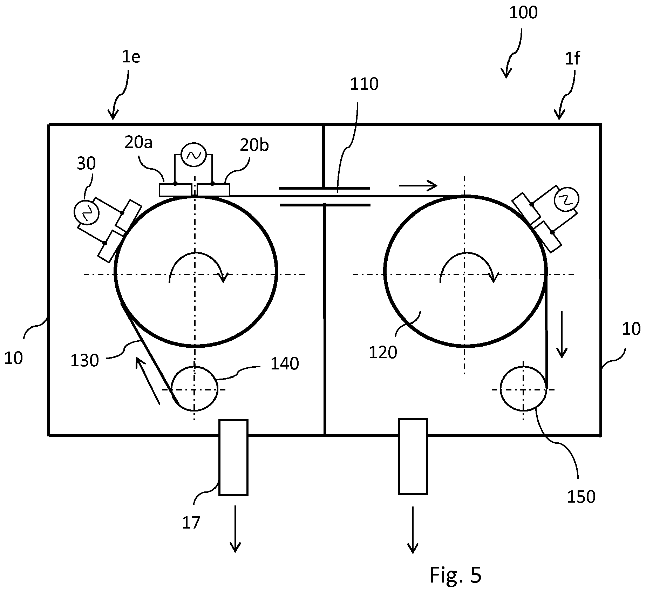

**Figur 5** zeigt schematisch eine Ausführungsform einer Prozesstrommelanlage (100), die zwei erfindungsgemäße und beispielhaft mit Bezug auf die Figuren 1 bis 4 erläuterte Plasmabehandlungsvorrichtungen (1e, 1f) enthält. Um die Übersichtlichkeit der Darstellung zu wahren, sind baugleiche Komponenten in beiden Plasmabehandlungsvorrichtungen (1e, 1f) nur mit Bezug auf eine der Plasmabehandlungsvorrichtung (1e oder 1f) mit einem Bezugszeichen versehen, die Gasversorgungssysteme nicht und die Spannungsquellen nur schematisch und nicht an ihrer realen räumlichen Position innerhalb der Plasmabehandlungsvorrichtung (1e, 1f) dargestellt. Beide Plasmabehandlungsvorrichtungen (1e, 1f) weisen eine Behandlungskammer (10) auf, die über eine Schleuse (110) miteinander verbunden sind und jeweils über einen Pumpenanschluss (17) verfügen. In jeder Plasmabehandlungsvorrichtung (1e, 1f) befindet sich eine Prozesstrommel (120), über die ein flexibles Substrat oder ein flexibler Substratträger (130) durch die Rotation der Prozesstrommel (120) geführt wird. Das flexible Substrat oder der flexible Substratträger (130) kann bspw. eine Folie sein, die in den Plasmabehandlungsvorrichtungen (1d, 1e) einer Behandlung unterzogen wird, und dabei von einer ersten Vorratsrolle (140) den Prozessen in der ersten Plasmabehandlungsvorrichtung (1e) zugeführt und nach den Prozessen in der zweiten Plasmabehandlungsvorrichtung (1f) auf eine zweite Vorratsrolle (150) wieder aufgewickelt wird.

In der ersten Plasmabehandlungsvorrichtung (1e) sind zwei Paare von Mikrowellenplasmaquellen (20a, 20b), wie sie mit Bezug auf die Fig. 1 bis4 beschrieben wurden, nacheinander angeordnet, wobei jedes Paar von Mikrowellenplasmaquellen (20a, 20b) mittels einer spezifischen Spannungsquelle (30) mit einer Spannung versorgt wird. Die beiden Paare von Mikrowellenplasmaquellen (20a, 20b) können jedoch auch von einer gemeinsamen Spannungsquelle (30) mit Spannung versorgt werden, wobei jeweils eine der Mikrowellenplasmaquellen (20a, 20b) jedes Paares von Mikrowellenplasmaquellen mit einem Ausgang der Spannungsquelle (30) und die jeweils andere Mikrowellenplasmaquellen (20a, 20b) jedes Paares von Mikrowellenplasmaquellen mit einem anderen Ausgang der Spannungsquelle (30) elektrisch leitend verbunden sind. Dabei können die mit dem gleichen Potential beaufschlagten Mikrowellenplasmaquellen (20a oder 20b) der beiden Paare von Mikrowellenplasmaquellen jeweils an derselben Position bezüglich der Transportrichtung des Substrates oder Substratträgers (130) (dargestellt durch den Pfeil entlang des Substrates oder Substratträgers) innerhalb des jeweiligen Paares von Mikrowellenplasmaquellen angeordnet sein oder an entgegengesetzten Positionen. Vorzugsweise führen beide Paare von Mikrowellenplasmaquellen (20a, 20b) dieselbe Behandlung des Substrates (130) oder der auf dem Substratträger (130) angeordneten Substrate aus.

In der zweiten Plasmabehandlungsvorrichtung (1f) ist in der in Fig. 5 dargestellten Ausführungsform nur ein Paar von Mikrowellenplasmaquellen (20a, 20b) angeordnet. Selbstverständlich können aber in beiden Plasmabehandlungsvorrichtungen (1e, 1f) ein, zwei oder mehr Paare von Mikrowellenplasmaquellen (20a, 20b) angeordnet sein. Vorzugsweise wird in der zweiten Plasmabehandlungsvorrichtung (1f) eine andere Behandlung des Substrates (130) oder der auf dem Substratträger (130) angeordneten Substrate vorgenommen als in der ersten Plasmabehandlungsvorrichtung (1e).

Vorteilhafterweise muss die Prozesstrommel (120) jeweils nicht mit einem definierten Potential beaufschlagt werden, da sie nicht als Bezugselektrode für eines der Plasmen der Mikrowellenplasmaquellen (20a, 20b) dient. Dies verlängert die Standzeit der Anlage und ermöglicht Kostensenkungen durch den einfacheren konstruktiven Aufbau der Prozesstrommel.

Wie bereits erwähnt, sind die Komponenten der Anlage nur schematisch dargestellt. So sind die Spannungsquellen (30) in der Realität vorzugsweise außerhalb der Behandlungskammern (10) angeordnet. Auch die erste und zweite Vorratsrolle (140, 150) können außerhalb der Behandlungskammern angeordnet sein.

### Bezugszeichen

- 1a-1f: Plasmabehandlungsvorrichtung
- 10: Behandlungskammer
- 11: Kammerwand
- 12: Öffnungsspalt
- 13: Substrat
- 14: Substratträger
- 15: Transportvorrichtung
- 16: Heizer
- 17: Pumpenanschluss
- 18: Erdung
- 19: Isolierte elektrische Durchführung
- 20a: Erste Mikrowellenplasmaquelle
- 20b: Zweite Mikrowellenplasmaquelle
- 21: Plasmaquellenwandung
- 22: Plasmaschirm
- 23: Mikrowelleneinkoppelvorrichtung
- 231: Innenleiter
- 232: Isolierrohr
- 241: oberer Gaseinlass
- 242: seitlicher Gaseinlass
- 243: mittlerer Gaseinlass
- 25: Magnetanordnung
- 251, 252: Magnete
- 26, 26': Elektrische Isolierung
- 27: Elektrische Verbindung zur Masse
- 28: Plasmaelektrode
- 29: Plasmaraum
- 29': Verbindungsbereich
- 291: Plasmaaustrittsöffnung
- 291': Ebene der Plasmaaustrittsöffnung
- 30, 30a, 30b: Spannungsquelle
- 31: Elektrische Zuleitung
- 40-43: Gasversorgung
- 44: Gaszuleitung
- 100: Prozesstrommelanlage
- 110: Schleuse
- 120: Prozesstrommel
- 130: Flexibles Substrat oder Substratträger
- 140, 150: Vorratsrolle

- A, B: sich gegenüberliegende Magnete der Mikrowellenplasmaquellen
- α, β: Neigungswinkel der Plasmaaustrittsöffnung gegenüber der Ebene der Substratoberfläche

## Patentansprüche

1. Plasmabehandlungsvorrichtung (1a;1b;1c;1d;1f) mit
- einer Behandlungskammer (10),
- mindestens einem Paar von Mikrowellenplasmaquellen (20a,20b) bestehend aus einer ersten Mikrowellenplasmaquelle (20a) und einer zweiten Mikrowellenplasmaquelle (20b), wobei die erste und die zweite Mikrowellenplasmaquelle (20a,20b) jeweils eine Plasmaquellenwandung (21) und innerhalb dieser eine Mikrowelleneinkoppelvorrichtung (23) aufweisen, wobei die erste und die zweite Mikrowellenplasmaquelle (20a,20b) innerhalb der Behandlungskammer (10) auf derselben Seite eines oder mehrerer zu bearbeitenden Substrate (13) und benachbart zueinander angeordnet sind;
**dadurch gekennzeichnet dass**
die erste Mikrowellenplasmaquelle (20a) und die zweite Mikrowellenplasmaquelle (20b) jeweils innerhalb der respektive Plasmawandung (21) eine respektive Plasmaelektrode (28) aufweisen,
dass die Plasmaelektroden (28) der ersten Mikrowellenplasmaquelle (20a) und der zweiten Mikrowellenplasmaquelle (20b) elektrisch isoliert voneinander sind, und
dass die Plasmabehandlungsvorrichtung (1a;1b;1c;1d;1e;1f) mindestens eine Spannungsquelle (30) aufweist, die mit den Plasmaelektroden (28) der ersten und der zweiten Mikrowellenplasmaquelle (20a,20b) elektrisch leitend verbunden und geeignet ist, diese mit unterschiedlichen Potentialen zu beaufschlagen.

2. Plasmabehandlungsvorrichtung (1a;1b;1c;1d;1e;1f) nach Anspruch 1, **dadurch gekennzeichnet, dass** die mindestens eine Spannungsquelle (30) einen ersten Ausgang und einen zweiten Ausgang aufweist und geeignet ist, zwischen dem ersten Ausgang und dem zweiten Ausgang eine Potenzialdifferenz zu erzeugen, wobei der erste Ausgang der Spannungsquelle (30) mit der Plasmaelektrode (28) der ersten Mikrowellenplasmaquelle (20a) und der zweite Ausgang der Spannungsquelle (30) mit der Plasmaelektrode (28) der zweiten Mikrowellenplasmaquelle (20b) des mindestens einen Paares von Mikrowellenplasmaquellen (20a,20b) verbunden ist.

3. Plasmabehandlungsvorrichtung (1a;1b;1c;1d;1e;1f) nach Anspruch 2, **dadurch gekennzeichnet, dass** die Spannungsquelle (30) eine symmetrische Spannungsquelle ist.

4. Plasmabehandlungsvorrichtung nach Anspruch 1, **dadurch gekennzeichnet, dass** die mindestens eine Spannungsquelle (30) eine Gleichspannungsquelle, eine gepulste Gleichspannungsquelle oder eine Wechselspannungsquelle ist.

5. Plasmabehandlungsvorrichtung (1a) nach Anspruch 1, **dadurch gekennzeichnet, dass** mindestens eine der ersten oder der zweiten Mikrowellenplasmaquelle (20a,20b) innerhalb der Plasmaquellenwandung (21) einen gegenüber Masse isolierten Plasmaschirm (22) aufweist, der einen Plasmaraum (29) der Mikrowellenplasmaquelle zumindest teilweise umgibt und als die respektive Plasmaelektrode (28) dient.

6. Plasmabehandlungsvorrichtung (1b;1c;1d;1e;1f) nach Anspruch 1, **dadurch gekennzeichnet, dass** die Plasmaquellenwandung (21) mindestens einer der ersten oder der zweiten Mikrowellenplasmaquelle (20a,20b) gegen Masse isoliert ist und als die respektive Plasmaelektrode (28) dient.

7. Plasmabehandlungsvorrichtung (1a;1b;1c;1d;1e;1f) nach Anspruch 1, **dadurch gekennzeichnet, dass** die einander zugewandten Seiten der Plasmaquellenwandung (21) der ersten und der zweiten Mikrowellenplasmaquellen (20a,20b) einen größeren Abstand zur Oberfläche des einen oder der mehreren zu bearbeitenden Substrate (13) aufweisen als die übrigen Seiten der Plasmaquellenwandungen (21).

8. Plasmabehandlungsvorrichtung (1a;1b;1c;1d;1e;1f) nach Anspruch 1, **dadurch gekennzeichnet, dass** mindestens eine der ersten und der zweiten Mikrowellenplasmaquelle (20a, 20b) gegenüber der Oberfläche der zu bearbeitenden Substrate (13) geneigt angeordnet ist.

9. Plasmabehandlungsvorrichtung (1a;1b;1e;1f) nach Anspruch 1, **dadurch gekennzeichnet, dass** die erste und die zweite Mikrowellenplasmaquelle (20a,20b) Magnete (251,252) aufweisen, wobei die sich gegenüberliegenden Magnete der ersten und der zweiten Mikrowellenplasmaquelle zueinander entweder gleichpolig oder gegenpolig angeordnet sind.

10. Plasmabehandlungsvorrichtung (1c;1d;1e;1f) nach Anspruch 1, **dadurch gekennzeichnet, dass** zwischen den einander zugewandten Seiten der Plasmaquellenwandung (21) der ersten und der zweiten Mikrowellenplasmaquellen (20a, 20b) ein Gaseinlass (241;242) angeordnet ist, der geeignet ist, ein Gas in einen Verbindungsbereich zwischen der ersten und der zweiten Mikrowellenplasmaquelle, der an die Oberfläche des einen oder der mehreren zu bearbeitenden Substrate (13) angrenzt, einzulassen.

11. Plasmabehandlungsvorrichtung (1a;b;1c;1d;1e;1f) nach Anspruch 1, **dadurch gekennzeichnet, dass** die Plasmabehandlungsvorrichtung einen gemeinsamen Mikrowellenleistungsteiler für die erste und die zweite Mikrowellenplasmaquelle (20a,20b) aufweist

12. Plasmabehandlungsvorrichtung (1a;1b;1c;1d;1e;1f) nach Anspruch 1, weiterhin enthaltend eine Transportvorrichtung (15), die geeignet ist, mindestens einen Substratträger (14), auf dem das eine oder die mehreren zu bearbeitenden Substrate (13) angeordnet sind, während des Betriebes der ersten und der zweiten Mikrowellenplasmaquellen (20a,20b) durch die Behandlungskammer (10) zu transportieren.

13. Plasmabehandlungsvorrichtung (1a;1b;1c;1d;1e;1f) nach Anspruch 12, **dadurch gekennzeichnet, dass** der Substratträger (14) aus einem elektrisch leitfähigen Material besteht.

14. Verfahren zum Betreiben einer Plasmabehandlungsvorrichtung (1a;1b;1c;1d;1e;1f) nach Anspruch 1 mit den Schritten:
- Zünden jeweils eines Plasmas in der ersten und der zweiten Mikrowellenplasmaquelle (20a, 20b) jeweils mit Hilfe einer Mikrowellenleistung und
- Beaufschlagen der Plasmaelektroden (28) der ersten Mikrowellenplasmaquelle (20a) und der zweiten Mikrowellenplasmaquelle (20b) mit unterschiedlichen Potentialen während der Aufrechterhaltung der Plasmen in den Mikrowellenplasmaquellen (20a,20b) mit Hilfe der mindestens einen Spannungsquelle (30), wobei die sich einstellenden Potentiale der Plasmen jeweils für das Plasma der anderen Mikrowellenplasmaquelle als Bezugspotential dienen.

15. Verfahren nach Anspruch 14, **dadurch gekennzeichnet, dass** die von der mindestens einen Spannungsquelle (30) bereitgestellte und über den Plasmen der ersten und der zweiten Mikrowellenplasmaquelle (20a,20b) abfallende Spannung eine Gleichspannung, eine gepulste Gleichspannung oder eine Wechselspannung ist.

16. Verfahren nach Anspruch 14, **dadurch gekennzeichnet, dass** das eine oder die mehreren zu bearbeitenden Substrate (13) während des Betriebes der ersten und der zweiten Mikrowellenplasmaquellen (20a,20b) durch die Plasmabehandlungsvorrichtung transportiert werden.

17. Verfahren nach Anspruch 14, **dadurch gekennzeichnet, dass** die Mikrowelleneinkoppelvorrichtung (13) der ersten und der zweiten Mikrowellenplasmaquelle (20a, 20b) mit einer phasengleich oder einer zueinander phasenversetzt gepulsten Mikrowellenleistung betrieben werden.

18. Verfahren nach Anspruch 17, **dadurch gekennzeichnet, dass** die phasengleich oder phasenversetzt gepulste Mikrowellenleistungen synchronisiert zu den Spannungsquellen (30) der ersten und zweiten Mikrowellenplasmaquelle (20a, 20b) betrieben werden.

## Claims

1. A plasma treatment device (1a; 1b; 1c; 1d; 1f) with
- a treatment chamber (10),
- at least one pair of microwave plasma sources (20a, 20b) consisting of a first microwave plasma source (20a) and a second microwave plasma source (20b), wherein the first and the second microwave plasma source (20a, 20b) each have a plasma source wall (21) and, within this, a microwave coupling-in device (23), wherein the first and the second microwave plasma source (20a, 20b) are arranged within the treatment chamber (10) on the same side of one or more substrates (13) to be processed and adjacently to one another,
**characterized in that**
the first microwave plasma source (20a) and the second microwave plasma source (20b) comprising each within the respective plasma source wall (21) a respective plasma electrode (28), and
that the plasma electrodes (28) of the first microwave plasma source (20a) and the second microwave plasma source (20b) are electrically insulated from one another, and
that the plasma treatment device (1a; 1b; 1c; 1d; 1e; 1f) comprises
- at least one voltage source (30), which is electrically conductively connected to the plasma electrodes (28) of the first and the second microwave plasma source (20a, 20b) and is suitable for applying different potentials thereto.

2. The plasma treatment device (1a; 1b; 1c; 1d; 1e; 1f) according to claim 1, **characterised in that** the at least one voltage source (30) has a first output and a second output and is suitable for generating a potential difference between the first output and the second output, wherein the first output of the voltage source (30) is connected to the plasma electrode (28) of the first microwave plasma source (20a) and the second output of the voltage source (30) is connected to the plasma electrode (28) of the second microwave plasma source (20b) of the at least one pair of microwave plasma sources (20a, 20b).

3. The plasma treatment device (1a; 1b; 1c; 1d; 1e; 1f) according to claim 2, **characterised in that** the voltage source (30) is a symmetrical voltage source.

4. The plasma treatment device according to claim 1, **characterised in that** the at least one voltage source (30) is a direct voltage source, a pulsed direct voltage source, or an alternating voltage source.

5. The plasma treatment device (1a) according to claim 1, **characterised in that** at least one of the first or second microwave plasma source (20a, 20b) has, within the plasma source wall (21), a plasma screen (22) insulated with respect to ground, which plasma screen (22) at least partially surrounds a plasma space (29) of the microwave plasma source and is used as the respective plasma electrode (28).

6. The plasma treatment device (1b; 1c; 1d; 1e; 1f) according to claim 1, **characterised in that** the plasma source wall (21) of at least one of the first or second microwave plasma source (20a, 20b) is insulated with respect to ground and is used as the respective plasma electrode (28).

7. The plasma treatment device (1a; 1b; 1c; 1d; 1e; 1f) according to claim 1, **characterised in that** the sides, facing one another, of the plasma source wall (21) of the first and second microwave plasma sources (20a, 20b) have a greater distance from the surface of the one or more substrates (13) to be processed compared to the other sides of the plasma source walls (21).

8. The plasma treatment device (1a; 1b; 1c; 1d; 1e; 1f) according to claim 1, **characterised in that** at least one of the first and second microwave plasma sources (20a, 20b) is arranged at an incline relative to the surface of the substrates (13) to be processed.

9. The plasma treatment device (1a; 1b; 1e; 1f) according to claim 1, **characterised in that** the first and the second microwave plasma source (20a, 20b) have magnets (251, 252), wherein the mutually opposed magnets of the first and second microwave plasma source are arranged either with identical polarity or with opposite polarity.

10. The plasma treatment device (1c; 1d; 1e; 1f) according to claim 1, **characterised in that** a gas inlet (241; 242) is arranged between the sides, facing one another, of the plasma source wall (21) of the first and second microwave plasma sources (20a, 20b), which gas inlet is suitable for admitting a gas into a connection region between the first and the second microwave plasma source, which connection region is adjacent to the surface of the one or more substrates (13) to be processed.

11. The plasma treatment device (1a; 1b; 1c; 1d; 1e; 1f) according to claim 1, **characterised in that** the plasma treatment device has a common microwave power splitter for the first and second microwave plasma source (20a, 20b).

12. The plasma treatment device (1a; 1b; 1c; 1d; 1e; 1f) according to claim 1, further containing a transport device (15) which is suitable for transporting at least one substrate carrier (14), on which the one or more substrates (13) to be processed are arranged, through the treatment chamber (10) during operation of the first and second microwave plasma sources (20a, 20b).

13. The plasma treatment device (1a; 1b; 1c; 1d; 1e; 1f) according to claim 12, **characterised in that** the substrate carrier (14) is made of an electrically conductive material.

14. A method for operating a plasma treatment device (1a; 1b; 1c; 1d; 1e; 1f) according to claim 1, said method comprising the following steps:
- igniting a plasma in each of the first and second microwave plasma source (20a, 20b), in each case with the aid of a microwave power, and
- supplying the plasma electrodes (28) of the first microwave plasma source (20a) and of the second microwave plasma source (20b) with different potentials during the maintenance of the plasmas in the microwave plasma sources (20a, 20b) with the aid of the at least one voltage source (30), wherein the resultant potentials of the plasmas are used in each case as reference potential for the plasma of the other microwave plasma source.

15. The method according to claim 14, **characterised in that** the voltage provided by the at least one voltage source (30) and dropping across the plasmas of the first and the second microwave plasma source (20a, 20b) is a direct voltage, a pulsed direct voltage, or an alternating voltage.

16. The method according to claim 14, **characterised in that** the one or more substrates (13) to be processed are transported through the plasma treatment device during the operation of the first and second microwave plasma sources (20a, 20b).

17. The method according to claim 14, **characterised in that** the microwave coupling-in devices (23) of the first and second microwave plasma source (20a, 20b) are operated with in-phase or phase-shifted pulsed microwave powers.

18. The method according to claim 17, **characterised in that** the in-phase or phase-shifted pulsed microwave powers are operated in a manner synchronised with the voltage sources (30) of the first and second microwave plasma source (20a, 20b).

## Revendications

1. Dispositif de traitement au plasma (1a ; 1b ; 1c ; 1d ; 1f) comprenant
- une chambre de traitement (10),
- au moins une paire de sources de plasma micro-ondes (20a, 20b) se composant d'une première source de plasma micro-ondes (20a) et d'une seconde source de plasma micro-ondes (20b), la première et la seconde source de plasma micro-ondes (20a, 20b) comportant respectivement une paroi de source de plasma (21) et, à l'intérieur de celle-ci, un dispositif de couplage à micro-ondes (23), la première et la seconde source de plasma micro-ondes (20a, 20b) étant disposées à l'intérieur de la chambre de traitement (10) sur le même côté d'un ou plusieurs substrats à traiter (13) et de manière adjacente l'une à l'autre ;
**caractérisé en ce que**
la première source de plasma micro-ondes (20a) et la seconde source de plasma micro-ondes (20b) comportent respectivement à l'intérieur de la paroi de source de plasma (21) respective, une électrode à plasma (28) respective, **en ce que** les électrodes à plasma (28) de la première source de plasma micro-ondes (20a) et de la seconde source de plasma micro-ondes (20b) sont isolées électriquement l'une de l'autre, et
**en ce que** le dispositif de traitement au plasma (1a ; 1b ; 1c ; 1d ; 1e ; 1f) comporte au moins une source de tension (30) qui est reliée de manière électriquement conductrice aux électrodes à plasma (28) de la première et de la seconde source de plasma micro-ondes (20a, 20b) et est apte à les soumettre à des potentiels différents.

2. Dispositif de traitement au plasma (1a ; 1b ; 1c ; 1d ; 1e ; 1f) selon la revendication 1, **caractérisé en ce que** l'au moins une source de tension (30) comporte une première sortie et une seconde sortie et est apte, entre la première sortie et la seconde sortie, à générer une différence de potentiel, la première sortie de la source de tension (30) étant reliée à l'électrode à plasma (28) de la première source de plasma micro-ondes (20a) et la seconde sortie de la source de tension (30) étant reliée à l'électrode à plasma (28) de la seconde source de plasma micro-ondes (20b), de l'au moins une paire de sources de plasma micro-ondes (20a, 20b).

3. Dispositif de traitement au plasma (1a ; 1b ; 1c ; 1d ; 1e ; 1f) selon la revendication 2, **caractérisé en ce que** la source de tension (30) est une source de tension symétrique.

4. Dispositif de traitement au plasma selon la revendication 1, **caractérisé en ce que** l'au moins une source de tension (30) est une source de tension continue, une source de tension continue pulsée ou une source de tension alternative.

5. Dispositif de traitement au plasma (1a) selon la revendication 1, **caractérisé en ce que** l'une au moins de la première ou de la seconde source de plasma micro-ondes (20a, 20b) comporte, à l'intérieur de la paroi de source de plasma (21), un écran plasma (22) isolé par rapport à la masse, qui entoure au moins partiellement une chambre de plasma (29) de la source de plasma micro-ondes et sert d'électrode au plasma (28) respective.

6. Dispositif de traitement au plasma (1a ; 1b ; 1c ; 1d ; 1e ; 1f) selon la revendication 1, **caractérisé en ce que** la paroi de source de plasma (21) de l'une au moins de la première ou de la seconde source de plasma micro-ondes (20a, 20b) est isolée par rapport à la masse et sert d'électrode au plasma (28) respective.

7. Dispositif de traitement au plasma (1a ; 1b ; 1c ; 1d ; 1e ; 1f) selon la revendication 1, **caractérisé en ce que** les côtés se faisant face de la paroi de source de plasma (21) de la première et de la seconde source de plasma micro-ondes (20a, 20b) sont à une plus grande distance de la surface des un ou plusieurs substrats à traiter (13) que les autres côtés des parois de source de plasma (21).

8. Dispositif de traitement au plasma (1a ; 1b ; 1c ; 1d ; 1e ; 1f) selon la revendication 1, **caractérisé en ce que** l'une au moins de la première et de la seconde source de plasma micro-ondes (20a, 20b) est disposée de manière inclinée par rapport à la surface des substrats à traiter (13).

9. Dispositif de traitement au plasma (1a ; 1b ; 1e ; 1f) selon la revendication 1, **caractérisé en ce que** la première et la seconde source de plasma micro-ondes (20a, 20b) comportent des aimants (251, 252), les aimants se faisant face de la première et de la seconde source de plasma micro-ondes étant disposés l'un par rapport à l'autre soit avec la même polarité soit avec une polarité opposée.

10. Dispositif de traitement au plasma (1c ; 1d ; 1e ; 1f) selon la revendication 1, **caractérisé en ce que**, entre les côtés se faisant face de la paroi de source de plasma (21) de la première et de la seconde source de plasma micro-ondes (20a, 20b) est disposée une entrée de gaz (241 ; 242) qui est apte à faire entrer un gaz dans une zone de raccordement entre la première et la seconde source de plasma micro-ondes qui est adjacente à la surface des un ou plusieurs substrats à traiter (13).

11. Dispositif de traitement au plasma (1a ; 1b ; 1c ; 1d ; 1e ; 1f) selon la revendication 1, **caractérisé en ce que** le dispositif de traitement au plasma comporte un répartiteur de puissance micro-ondes commun à la première et à la seconde source de plasma micro-ondes (20a, 20b).

12. Dispositif de traitement au plasma (1a ; 1b ; 1c ; 1d ; 1e ; 1f) selon la revendication 1, contenant en outre un dispositif de transport (15) qui est apte à transporter au moins un porte-substrats (14), sur lequel sont disposés les un ou plusieurs substrats à traiter (13), pendant l'utilisation de la première et de la seconde source de plasma micro-ondes (20a, 20b) à travers la chambre de traitement (10).

13. Dispositif de traitement au plasma (1a ; 1b ; 1c ; 1d ; 1e ; 1f) selon la revendication 12, **caractérisé en ce que** le porte-substrats (14) est composé d'un matériau électriquement conducteur.

14. Procédé de fonctionnement d'un dispositif de traitement au plasma (1a ; 1b ; 1c ; 1d ; 1e ; 1f) selon la revendication avec les étapes suivantes :
- amorcer un plasma dans la première et la seconde source de plasma micro-ondes (20a, 20b) respectivement à l'aide d'une puissance micro-ondes et
- soumettre les électrodes à plasma (28) de la première source de plasma micro-ondes (20a) et de la seconde source de plasma micro-ondes (20b) à différents potentiels pendant la conservation des plasmas dans les sources de plasma micro-ondes (20a, 20b) à l'aide de l'au moins une source de tension (30),
les potentiels réglables des plasmas servant respectivement de potentiel de référence pour le plasma de l'autre source de plasma micro-ondes.

15. Procédé selon la revendication 14, **caractérisé en ce que** la tension fournie par l'au moins une source de tension (30) et chutant aux bornes des plasmas de la première et de la seconde source de plasma micro-ondes (20a, 20b) est une tension continue, une tension continue pulsée ou une tension alternative.

16. Procédé selon la revendication 14, **caractérisé en ce que** les un ou plusieurs substrats à traiter (13) sont transportés à travers le dispositif de traitement au plasma pendant l'utilisation de la première et de la seconde source de plasma micro-ondes (20a, 20b).

17. Procédé selon la revendication 14, **caractérisé en ce que** le dispositif de couplage à micro-ondes (13) de la première et de la seconde source de plasma micro-ondes (20a, 20b) est utilisé avec une puissance micro-ondes pulsée de même phase ou déphasée.

18. Procédé selon la revendication 17, **caractérisé en ce que** les puissances micro-ondes pulsées de même phase ou déphasées sont utilisées de manière synchronisée avec les sources de tension (30) de la première et de la seconde source de plasma micro-ondes (20a, 20b).
